(19) Europäisches Patentamt
European Patent Office
Office européen des brevets

(11) **EP 0 527 319 B1**

(12) **EUROPÄISCHE PATENTSCHRIFT**

(45) Veröffentlichungstag und Bekanntmachung des Hinweises auf die Patenterteilung:
**25.08.1999 Patentblatt 1999/34**

(51) Int Cl.⁶: **H04N 9/64**, H04N 9/78, H03H 17/04

(21) Anmeldenummer: **92110985.6**

(22) Anmeldetag: **29.06.1992**

(54) **Verfahren zur Signalverarbeitung**

Signal processing method

Procédé de traitement d'un signal

(84) Benannte Vertragsstaaten:
**DE FR GB SE**

(30) Priorität: **26.07.1991 DE 4124834**

(43) Veröffentlichungstag der Anmeldung:
**17.02.1993 Patentblatt 1993/07**

(73) Patentinhaber: **Daimler-Benz Aerospace Aktiengesellschaft**
**81663 München (DE)**

(72) Erfinder:
• **Nagel, Dieter, Dr.**
**W-7900 Ulm-Wiblingen (DE)**

• **Wolf, Günter, Dipl.-Ing.**
**W-7900 Ulm (DE)**

(56) Entgegenhaltungen:
EP-A- 0 272 714    EP-A- 0 516 216
FR-A- 2 532 504    US-A- 4 698 680

• **THEORY AND APPLICATION OF DIGITAL SIGNAL PROCESSING 5. Dezember 1976 Seiten 551 - 557 L.RABINER ET AL 'Verlag: PRENTICE-HALL, INC. Englewood Cliffs, New Jersey'**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft ein Verfahren zur Signalverarbeitung nach dem Oberbegriff des Patentanspruchs 1.

Die Erfindung ist insbesondere anwendbar auf die Verarbeitung eines elektrischen Signals, das einen im wesentlichen monochromatischen Signalanteil enthält, welcher unterdrückt werden soll. Ein solches elektrisches Signal tritt z. B. bei der Nachrichtenübertragung mit Hilfe eines sogenannten Trägersignals auf. Dabei dient das Trägersignal bei einem Nachrichtenempfänger lediglich zur Abstimmung des Empfängers auf einen gewünschten Nachrichtensender. Zur Auswertung der Nachrichten muß das Trägersignal empfangsseitig unterdrückt werden, da es keine Nachrichteninformation enthält. Das Trägersignal kann hier auch als monochromatischer Signalanteil des gesamten Signals bezeichnet werden, den man mit einem Filter, z.B. einem digitalen Filter, möglichst gut unterdrücken möchte. Ein solches Filter besitzt eine mehr oder minder lange Einschwingzeit, die aber im allgemeinen nicht störend ist, da sie die Nachrichtenauswertung allenfalls kurzzeitig verhindert, z. B. dann, wenn der Nachrichtenempfänger von einem ersten Trägersignal (erster Sender) auf ein zweites Trägersignal (zweiter Sender) abgestimmt wird. In diesem Fall kann eine zuverlässige Nachrichtenauswertung des beispielhaft erwähnten zweiten Senders erst nach der Einschwingzeit des Filter für den monochromatischen Signalanteil erfolgen. Tritt ein Wechsel des Trägersignals selten auf, so ist auch die auftretende Einschwingzeit des Filters vernachlässigbar. Wird aber das Trägersignal relativ häufig unterbrochen, z. B. durch Schaltvorgänge, so kann aufgrund der Einschwingzeit des Filters ein erheblicher Anteil der Nachrichteninformation in störender Weise verlorengehen.

Aus der US 4,698,680 ist ein Verfahren bekannt, mit dem bei einem Fernsehempfänger sogenannte Geisterbilder vermieden werden können. Dafür wird ein IIR-Filter verwendet, dessen Filterkoeffizienten in Abhängigkeit von dem empfangenen Signal und den darin enthaltenen Störungen derart programmiert werden, daß diejenigen Signalanteile, die Geisterbilder verursachen, ausgefiltert werden.

Aus der FR-A-2 532 504 ist weiterhin ein Farbfernsehempfänger bekannt, bei welchem das Farbsignal mittels eines FIR-Filters, das programmierbare Filterkoeffizienten besitzt, derart gefiltert wird, daß ein an sich vorhandener Rauschanteil unterdrückt wird. Diese Filterung des Farbsignals unterliegt Verfahrensschritten, wie sie im Oberbegriff des Anspruches 1 vorliegenden Schutzrechts angegeben sind.

Der Erfindung liegt die Aufgabe zugrunde, das gattungsgemäße Verfahren dahingehend zu verbessern, daß bei einem digitalen Filter eine vernachläßigbare Einschwingzeit entsteht.

Diese Aufgabe wird gelöst durch die im kennzeichnenden Teil des Patentanspruchs 1 angegebenen Merkmale. Vorteilhafte Ausgestaltungen und/oder Weiterbildungen sind den Unteransprüchen entnehmbar.

Ein erster Vorteil der Erfindung besteht darin, daß es unter bestimmten technisch realisierbaren Voraussetzungen sogar möglich ist, ein Filter mit der Einschwingzeit Null für den monochromatischen Signalanteil zu verwirklichen.

Ein zweiter Vorteil besteht darin, daß es aufgrund der kurzen Einschwingzeit des Filters für den monochromatischen Signalanteil möglich ist, dieses Filter überall dort einzusetzen, wo ein getaktetes (geschaltetes) Trägersignal, das auch als Burst bezeichnet wird, zuverlässig unterdrückt werden muß.

Ein dritter Vorteil besteht darin, bei Signalverarbeitungsverfahren, die auf einer Verwendung getakteter Trägersignale ("Bursts") beruhen, die zeitliche Länge der Bursts sehr stark zu verkürzen und trotzdem eine zuverlässige Signalauswertung zu erhalten.

Die Erfindung beruht auf der Erkenntnis, daß es in überraschender Weise möglich ist, ein digitales Filter, das als IIR-Filter ("Infinite Impulse Response"-Filter) ausgebildet ist, also ein Filter mit einer nominell unendlich langen Impuls-Antwortzeit, so auszubilden, daß dieses IIR-Filter für einen monochromatischen Signalanteil eine vernachlässigbare Einschwingzeit besitzt, welche unter bestimmten nachfolgend näher erläuterten Voraussetzungen sogar genau Null werden kann.

Ein digitales Filter enthält im Prinzip mehrere hintereinander geschaltete Verzögerungsglieder, die von einem Eingangssignal zeitlich nacheinander durchlaufen werden. Damit entstehen also mehrere zeitlich verzögerte Signale, die entsprechend der gewünschten Filtercharakteristik gewichtet, das heißt, mit einem Faktor multipliziert, und anschließend addiert werden.

Wie bereits erwähnt, hat ein IIR-Filter eine nominell zeitlich unendlich lange Impulsantwort, deren Signalamplitude bei einem elektrisch stabilen Filtersystem nach unendlich langer Zeit gegen den Grenzwert Null strebt. Bei technisch verwirklichten IIR-Filtern klingt die Signalamplitude nach einer vorgebbaren Zeit, z. B. einige Sekunden, auf einen vorgebbaren Wert ab, z. B. auf ein Hundertstel des Anfangswertes, so daß der Einschwingvorgang nach dieser Zeit als beendet angesehen wird. Dabei hängen die Ausgangswerte (Ausgangsamplituden) von den entsprechenden Eingangswerten (Eingangsamplituden) und dem sogenannten Zustandsvektor (Gedächtnis) des IIR-Filters ab. Ist das Eingangssignal des IIR-Filters z. B. eine monochromatische Schwingung, die zu einem bestimmten, vorgebbaren Zeitpunkt sprungförmig aufgeschaltet wird, das heißt, von dem Amplitudenwert Null auf einen vorgebbaren maximalen Amplitudenwert, so nimmt ein das IIR-Filter kennzeichnender Zustandsvektor erst nach der erwähnten langen Einschwingzeit einem dem monochromatischen Signalanteil entsprechenden Verlauf an.

Kennt man nun zu einem bestimmten Zeitpunkt, an welchem die monochromatische Schwingung am Eingang des IIR-Filter sprunghaft aufgeschaltet wird, Betrag, Phase und Frequenz der Schwingung, so kann man mit Hilfe der ebenfalls bekannten Übertragungsfunktion des IIR-Filters einen dem eingeschwungenen Zustand entsprechenden Zustandsvektor bestimmen. Wird nun das IIR-Filter vor dem Zeitpunkt des sprunghaften Aufschaltens der monochromatischen Schwingung auf einen entsprechenden Zustandsvektor eingestellt, so befindet sich das IIR-Filter zum Zeitpunkt des Aufschaltens bereits in seinem eingeschwungenen Zustand und hat damit die Einschwingzeit Null. Betrag, Phase und Frequenz der Schwingung können z. B. durch einen nachfolgend näher erläuterten Meßvorgang bestimmt werden.

Es ist also z. B. möglich, in einer dem Eingang des IIR-Filters vorgeschalteten Anordnung bei einem zeitlich getasteten Trägersignal ("Burst") dessen Betrag, Phase und Frequenz zu messen und den Burst solange zu verzögern, bis der erwähnte Zustandsvektor bestimmt ist. Anschließend wird das IIR-Filter auf diesen Zustandsvektor eingestellt. Erst dann wird der Burst an den Eingang des Filters gelegt, welches sich dann in dem eingeschwungenen Zustand für den monochromatischen Signalanteil befindet. Ist das IIR-Filter nun beispielsweise als Sperrfilter für den monochromatischen Signalanteil ausgebildet, so entstehen am Ausgang des IIR-Filters lediglich Signalanteile, z. B. entsprechend einem Seitenband des Trägersignals, welches die auszuwertenden Nachrichten beinhalten.

Die Erfindung wird im folgenden anhand von Ausführungsbeispielen unter Bezugnahme auf schematisch dargestellte Figuren näher erläutert. Es zeigen

FIG. 1 ein schematisches Blockschaltbild eines ersten Ausführungsbeispiels eines rekursiven IIR-Filters in der zweiten direkten Form mit einer minimalen Anzahl von Speicherelementen;

FIG. 2 ein schematisches Blockschaltbild eines zweiten Ausführungsbeispiels eines IIR-Filters mit einer Kaskadenschaltung mehrerer Untersysteme, die ebenfalls in der zweiten direkten Form entsprechend FIG. 1 aufgebaut sind.

FIG. 3 bis 8 schematische Diagramme zur Erläuterung der Erfindung.

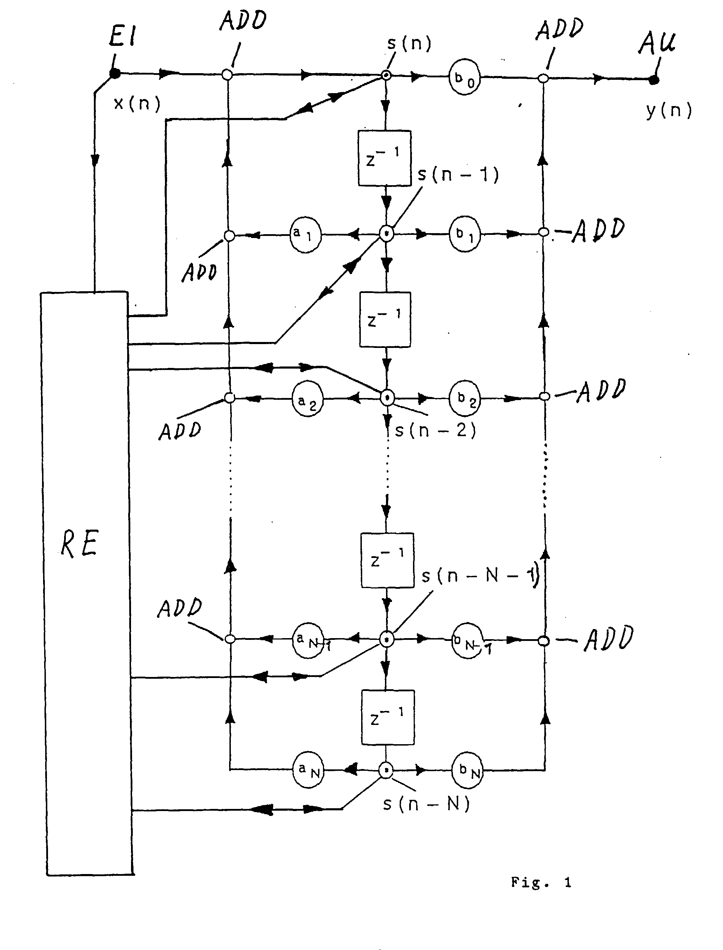

Das in FIG. 1 dargestellte IIR-Filter in der zweiten direkten Form besteht im wesentlichen aus einer Hintereinanderschaltung von Verzögerungsgliedern $z^{-1}$, die alle dieselbe Verzögerungszeit besitzen. An den Ein- sowie den Ausgängen der Verzögerungsglieder $z^{-1}$ befinden sich einstellbare Speicherelemente $s(n)$ bis $s(n-N)$, die vorteilhafterweise mit Hilfe einer Recheneinheit RE eingestellt werden. Diesen nachgeschaltet sind feste Multiplikationsglieder $a_1$ bis $a_N$ sowie $b_0$ bis $b_N$, die zur Einstellung der Filterkoeffizienten und damit zur Charakteristik des Filters dienen. Den festen Multiplikationsgliedern sind Additionsglieder ADD nachgeschaltet, so daß die in FIG. 1 dargestellte rasterförmige Anordnung entsteht. Durch die Pfeile ist der Signalfluß dargestellt. Aus einem am Filtereingang EI anliegenden Eingangssignal $x(n)$ entsteht daraus am Filterausgang AU ein Ausgangssignal $y(n)$. Dabei liegen $x(n)$, $y(n)$ zweckmäßigerweise als digitale Abtastwerte einer zeitabhängigen Funktion vor. Mit n ist die Nummer des Abtastwertes bezeichnet, n ist daher auch ein Maß für die Zeit.

Die Wirkungsweise eines solchen IIR-Filters wird im folgenden mit Hilfe der in der Nachrichtentechnik üblichen z-Transformation erläutert. Dabei bedeutet z eine komplexe Variable (Rechengröße) aus dem z-Bereich (z-Ebene). Dem Eingangssignal $x(n)$ und dem Ausgangssignal $y(n)$ werden die z-Transformierten $X(z)$ bzw. $Y(z)$ zugeordnet. Das rekursive IIR-Filter gemäß FIG. 1 ist darstellbar durch die gebrochen rationale Übertragungsfunktion $H(z)$ gemäß der Formel:

$$H(z) = \frac{\sum\limits_{k=0}^{N} b_k z^{-k}}{1 - \sum\limits_{k=1}^{N} a_k z^{-k}} \qquad (1)$$

wobei k eine laufende Variable bedeutet und N die sogenannte Länge des Filters angibt. N ist auch gleich der Anzahl der Verzögerungsglieder $z^{-1}$ und der Anzahl der einstellbaren Multiplikationsglieder $s(n)$ bis $s(n-N)$, die in der mathematischen Darstellung auch als Zustände bezeichnet werden. $a_k$ und $b_k$ bezeichnen die bereits erwähnten Filterkoeffizienten, die auch als feste Multiplikationsglieder realisiert werden können.

Das Ausgangssignal $y(n)$ hängt vom Eingangssignal $x(n)$ und den N Zuständen $s(n-1)$, $s(n-2)$, ..., $s(n-N)$ ab

gemäß den Formeln

$$y(n) = \sum_{k=0}^{N} b_k s(n-k) \qquad (2a)$$

$$s(n) = x(n) + \sum_{k=1}^{N} a_k s(n-k) \qquad (2b)$$

Dabei läßt sich der Zustand s(n) zum Zeitpunkt n nach G1. (2b) durch das Eingangssignal x(n) und allen anderen Zustandswerten ausdrücken. Die Übertragungsfunktion zwischen dem Zustand s(n) mit der zugehörigen z-Transformierten S(z) und dem Eingangssignal x(n) mit der zugehörigen z-Transformierten X(z) ist bestimmt aus der Formel

$$S(z) = \frac{1}{1 - \sum_{k=1}^{N} a_k z^{-k}} X(z) \qquad (3)$$

Die Werte der Zustände s(n-i) an den Zeitpunkten n-i, mit i=1, ..., N, sind im z-Bereich bestimmbar durch Multiplikation der Formel (3) mit $z^{-i}$:

$$s(n-i) \; \circ\!\!-\!\!\cdot \; S(z)z^{-i} \qquad (4)$$

wobei $\circ\!\!-\!\!\cdot$ ein Symbol für die zugehörige z-Transformation bedeutet.

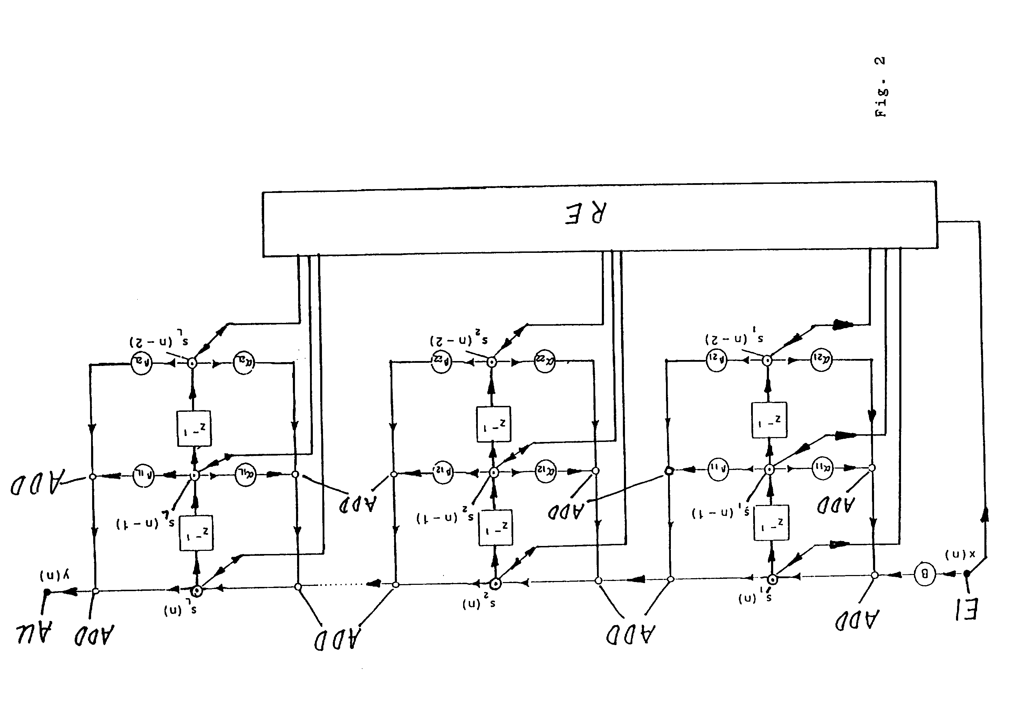

FIG. 2 zeigt ein weiteres Ausführungsbeispiel eines IIR-Filters, das eine sogenannte Kaskadenstruktur besitzt. Diese besteht aus einer Hintereinanderschaltung aus einer Anzahl L von Untersystemem, die als Systeme zweiter Ordnung ausgebildet sind und die ebenfalls in der zweiten direkten Form realisiert sind. Die Bezugszeichen in FIG. 2 entsprechen denjenigen der FIG. 1, jedoch ist es aufgrund der Kaskadenstruktur erforderlich, sowohl die einstellbaren Multiplikationsglieder $s_k(n)$ als auch die festen Multiplikationglieder α, β (Filterkoeffizienten) mit einem tiefgestellten Index k, k=1 ... L zu bezeichnen. Dem Filtereingang EI ist ein weiteres festes Multiplikationglied B nachgeschaltet. Das IIR-Filter in FIG. 2 ist im z-Bereich beschreibbar durch eine der Formel (1) entsprechende Übertragungsfunktion H(z) gemäß der Formel

$$H(z) = B \prod_{k=1}^{L} \frac{1+\beta_{1k}z^{-1}+\beta_{2k}z^{-2}}{1-\alpha_{1k}z^{-1}-\alpha_{2k}z^{-2}} \qquad (5)$$

$$L = INT \left[ \frac{N+1}{2} \right]$$

4

wobei durch die Funktion INT die größte ganze Zahl des nachfolgenden Klammerausdrucks ermittelt wird.

Das am Ausgang AU des IIR-Filters entstehende Ausgangssignal $y(n)$ ergibt sich aus den Zuständen der einstellbaren Speicherglieder $s_i(n-1)$, $s_i(n-2)$, $i=1, ..., L$ und dem Eingangssignal $x(n)$ wie folgt:

$$
\begin{aligned}
y(n) \ &= \ s_L(n)+\beta_{1L}s_L(n-1)+\beta_{2L}s_L(n-2)\\
s_L(n) \ &= \ s_{L-1}(n)+\beta_{1(L-1)}s_{L-1}(n-1)+\beta_{2L-1}s_{L-1}(n-2)\\
&\quad +\alpha_{1L}s_L(n-1)+\alpha_{2L}s_L(n-2)\\
&\ \vdots \\
s_2(n) \ &= \ s_1(n)\beta_{11}s_1(n-1)+\beta_{21}s_1(n-2)\\
&\quad +\alpha_{12}s_2(n-1)+\alpha_{22}s_2(n-2)\\
s_1(n) \ &= \ Bx(n)+\alpha_{11}s_1(n-1)+\alpha_{21}s_1(n-2)
\end{aligned}
\tag{6}
$$

Daraus lassen sich die für das IIR-Filter wichtigen Übertragungsfunktionen ableiten gemäß den Formeln:

$$
\begin{aligned}
s_L(n) \ \circ\!\!-\!\!\cdot\ S_L(z) \ &= \ \frac{1+\beta_{1(L-1)}z^{-1}+\beta_{2(L-1)}z^{-2}}{1-\alpha_{1L}z^{-1}-\alpha_{2L}z^{-2}}\ S_{L-1}(z)\\
&\ \vdots \\
s_2(n) \ \circ\!\!-\!\!\cdot\ S_2(z) \ &= \ \frac{1+\beta_{11}z^{-1}+\beta_{21}z^{-2}}{1-\alpha_{12}z^{-1}-\alpha_{22}z^{-2}}\ S_1(z)\\
\\
s_1(n) \ \circ\!\!-\!\!\cdot\ S_1(z) \ &= \ \frac{B}{1-\alpha_{11}z^{-1}-\alpha_{21}z^{-2}}\ X(z)
\end{aligned}
\tag{7}
$$

Da in den L Untersystemen nur Filtersysteme zweiter Ordnung vorhanden sind, ergeben sich alle weiteren Zustände durch Multiplikation mit $z^{-1}$ und $z^{-2}$:

$$
\begin{aligned}
s_1(n-1) \ &\circ\!\!-\!\!\cdot\ S_1(z)z^{-1}\\
s_1(n-2) \ &\circ\!\!-\!\!\cdot\ S_1(z)z^{-2}, \ l=1, ... L
\end{aligned}
\tag{8}
$$

In der bisherigen Beschreibung wurden die IIR-Filter entsprechend FIG. 1 und FIG. 2 lediglich im z-Bereich betrachtet und die zugehörigen Übertragungsfunktionen ermittelt. Im folgenden wird der zugehörige Bezug zu realen elektrischen Signalen hergestellt und die zugehörigen Parameter bestimmt.

Ein beliebiges monochromatisches Signal, das durch die reelle Amplitude A und die Frequenz $\omega_1$ gekennzeichnet ist, das entsprechend dem Abtasttheorem mit der Abtastfrequenz $f_a$ abgetastet wird und das zum Zeitpunkt $n=0$ aufgeschaltet wird, ist beschreibbar durch die Formeln

$$x(n) = Ae^{j(\Omega_1 n + \Phi_1)} \qquad \text{für } n \geq 0 \qquad\qquad (9)$$

$$x(n) = 0 \qquad \text{für } n < 0$$

$$j^2 = -1$$

Dabei ist $\Phi_1$ die Phase zum Abtastzeitpunkt n=0 und $\Omega_1$ die normierte Frequenz des Signals. $\Omega_1$ ist dimensionslos und entspricht der auf die Abtastfrequenz $f_a$ bezogene Frequenz $\omega_1$ gemäß der Formel

$$\Omega_1 = \frac{\omega_1}{f_a} \qquad\qquad 10)$$

Liegen zwei komplexe Abtastwerte x(0) und x(1) vor, so können aus diesen die Parameter A, $\Omega_1$ und $\Phi_1$ bestimmt werden :

$$x(0) = Ae^{j\Phi_1} \qquad\qquad (11)$$

$$x(1) = Ae^{j(\Omega_1 n + \Phi_1)}$$

Daraus folgt:

$$\Omega_1 = -j \ln \frac{x(1)}{x(0)}$$

$$A = |x(0)| = |x(1)| \qquad\qquad (12)$$

$$\Phi_1 = -j \ln \frac{x(0)}{A}$$

ln = natürlicher Logarithmus

Wie bereits eingangs erwähnt, wird ein Einschwingen des IIR-Filters dadurch verhindert, daß dessen Zustände, bzw. das Gedächtnis des Filters, mit bestimmten Werten vorbesetzt werden.

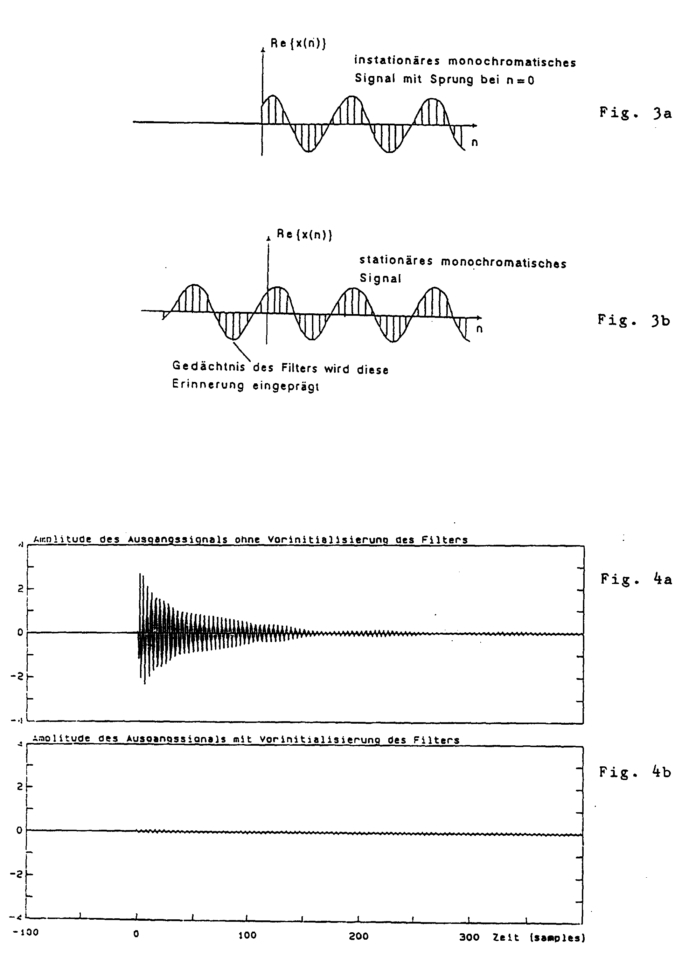

Soll ein Einschwingen des Filters verhindert werden, so muß der tatsächliche Signalverlauf, der zu einem bestimmten Zeitpunkt einen Sprung aufweist, fiktiv verändert werden. Dies geschieht, indem das nach dem Sprung präsente monochromatische Signal so in die Vergangenheit fortgesetzt wird, als wäre kein Sprung vorhanden. Damit wird aus dem instationären Signalverlauf gemäß Formel (9) (FIG. 3a) ein stationäres Signal (FIG. 3b) erzeugt. Hiermit kann bei der Berechnung des Zustandsvektors der Frequenzgang des Filters benutzt werden. Mit der Berechnung des Zustandsvektors ist es möglich, dem Gedächtnis des Filters unmittelbar eine Erinnerung einzuprägen, die eigentlich erst nach unendlich langer Einschwingzeit vorhanden wäre.

Das in FIG. 3b dargestellte Signal ist monochromatisch im Bereich -∞ bis +∞. Dieses wird dargestellt durch eine Signalfolge $\hat{x}(n)$ gemäß der Formel

$$\hat{x}(n) = Ae^{j(\Omega_1 n + \Phi_1)} \qquad -\infty < n < \infty \; . \qquad\qquad (13)$$

Bei dem IIR-Filter in FIG. 1 sind Zustand s(n) und Eingangssignal x(n) nach Formel (3) durch eine Übertragungsfunktion verknüpft. Da hier nur der eingeschwungene Zustand s(n) interessiert und x(n) ein monochromatisches Signal der Frequenz $\Omega_1$ ist, kann $z = e^{j\Omega_1}$ gesetzt werden.

Damit erhält man aus Formel (3) die Formel

$$s(n) = \frac{1}{1 - \sum\limits_{k=1}^{N} a_k e^{-j\Omega_1 k}} \cdot A e^{j(\Omega_1 n + \Phi_1)} \tag{14}$$

Nach Formel (11) galt:

$$x(0) = A e^{j\Phi_1}$$

$$\frac{x(1)}{x(0)} = e^{j\Omega_1} \tag{15}$$

womit unmittelbar s(n) in Abhängigkeit von x(0), x(1) und den Filterkoeffizienten $a_k$, k=1, ..., N angegeben werden kann:

$$s(n) = \frac{1}{1 - \sum\limits_{k=1}^{N} a_k \left[\frac{x(1)}{x(0)}\right]^{-k}} x(0) \left[\frac{x(1)}{x(0)}\right]^{n} \tag{16}$$

Demnach kann anhand der beiden ersten Abtastwerte x(0), x(1) das Gedächtnis des Filters, d. h. die Zustandswerte s(-1), s(-2), ..., s(-N) so bestimmt werden, daß bei sprungförmiger Aufschaltung des monochromatischen Signals das IIR-Filter unmittelbar in seinem eingeschwungenem Zustand ist.

Etwas schwieriger sind die Signalverläufe der Zustände $s_1(n)$, $s_1(n-1)$ und $s_1(n-2)$, l=1, ..., L für die Kaskadenstruktur nach FIG. 2 zu bestimmen. Dies muß sukzessive erfolgen. Es wird mit dem Zustand $s_1(n)$ begonnen und man erhält aus Formel (7) analog zu Formel (16) :

$$s_1(n) = \frac{B}{1 - \alpha_{11}\left[\frac{x(1)}{x(0)}\right]^{-1} - \alpha_{21}\left[\frac{x(1)}{x(0)}\right]^{-2}} x(0) \left[\frac{x(1)}{x(0)}\right]^{n} \tag{17}$$

Nimmt man die Eingangssignalfolge $\hat{x}(n)$ nach Formel (13), so können die Signalverläufe der Zustände allesamt als komplexe Schwingungen angegeben werden :

$$s_1(n) = A_1 e^{j(\Omega_1 n + \Phi_{l1})}, \qquad l=1,...,L \tag{18}$$

In den einzelnen Übertragungsfunktionen wird $z = e^{j\Omega_1}$ eingesetzt und damit erhält man aus Formel (7) :

$$s_1(n) = \frac{1 + \beta_{1(l-1)}e^{-j\Omega_1} + \beta_{2(l-1)}e^{-j2\Omega_1}}{1 - \alpha_{1l}e^{-j\Omega_1} - \alpha_{2l}e^{-j2\Omega_1}} A_{l-1}e^{j(\Omega_1 n + \Phi_{(l-1)1})} \qquad (19)$$

Mit den Formeln

$$s_1(0) = A_1 e^{j\Phi_{11}} \qquad\qquad (20)$$

$$\frac{x(1)}{x(0)} = e^{j\Omega_1}$$

folgt

$$s_1(n) = \frac{1 + \beta_{1(1-1)}\left[\frac{x(1)}{x(0)}\right]^{-1} + \beta_{2(1-1)}\left[\frac{x(1)}{x(0)}\right]^{-2}}{1 - \alpha_{11}\left[\frac{x(1)}{x(0)}\right]^{-1} - \alpha_{21}\left[\frac{x(1)}{x(0)}\right]^{-2}} s_{1-1}(0)\left[\frac{x(1)}{x(0)}\right]^{n} \qquad (21)$$

$$1 = 2, \ldots, L$$
$$n = 0, -1, -2$$

Mit den Formeln (17) und (21) wird nun das Gedächtnis eines Filters in der Kaskadenstruktur bestimmt, wenn bei sprungförmiger Aufschaltung eines monochromatischen Signals das Filter keinen Einschwingvorgang aufweisen soll.

Enthält das Eingangssignal x(n) nur einen monochromatischen Anteil, so sind die Zustände zur Vermeidung des Einschwingvorgangs exakt vorbestimmbar. FIG. 4 zeigt am Beispiel eines Cauerfilters (4ter Ordnung, Kaskadenstruktur), das als Sperrfilter für ein monochromatisches Signal ausgelegt ist, die Filterantwort auf ein sprungförmig aufgeschaltetes monochromatisches Signal. Dabei zeigt FIG. 4a den Einschwingvorgang für den Fall, daß die Zustände nicht vorbesetzt wurden, das heißt, alle Speicher s(n) weisen zum Zeitpunkt n=0 den Wert Null auf.

FIG. 4b zeigt den Fall, daß alle Zustände entsprechend den Formeln (17) und (21) vorbesetzt wurden. Es ist daher deutlich sichtbar, daß vorteilhafterweise kein Einschwingvorgang vorhanden ist.

In dem Fall entsprechend FIG. 4a, 4b wird davon ausgegangen, daß dem monochromatischen Signal kein Störsignal, insbesondere Rauschen, überlagert ist.

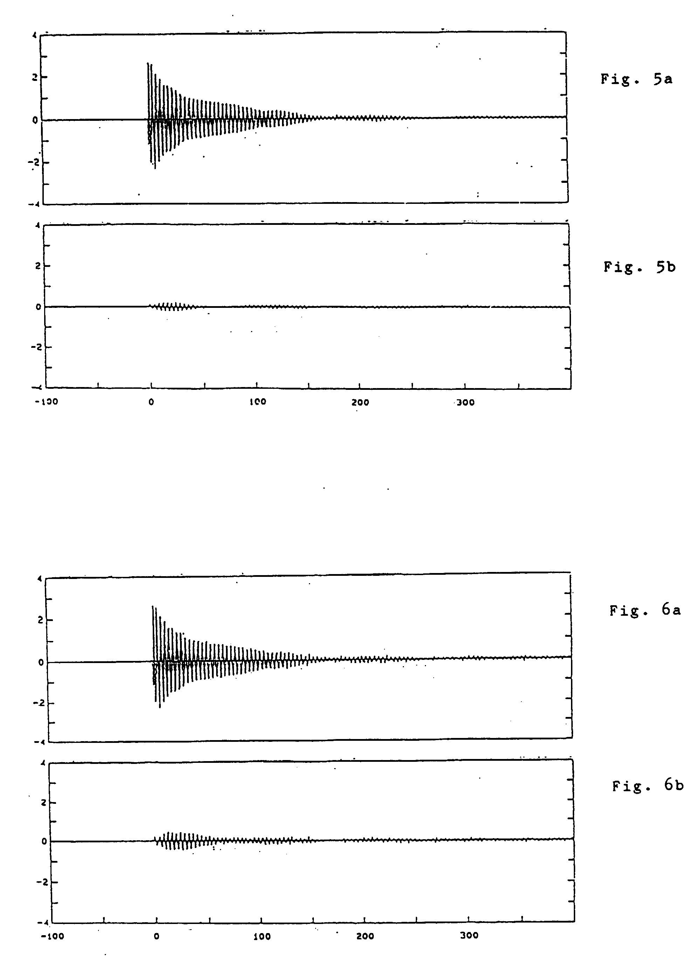

In den folgenden Beispielen entsprechend FIG. 5a bis 8b wird dargelegt, wie sich ein dem monochromatischen Signal überlagertes Rauschen auf die Messung von reeller Amplitude, Phase und Frequenz auswirkt und wie dadurch bedingte Ungenauigkeiten die Einstellung der Zustände beeinflussen.

Ist das monochromatische Signal von Rauschen r(n) überlagert, so ist das aufgeschaltete Eingangssignal x(n) darstellbar durch die Formel

$$x(n) = Ae^{j(\Omega_1 n + \Phi_1)} + r(n) \qquad n \geq 0 \qquad (22)$$

$$x(n) = 0 \qquad n < 0.$$

In diesem Fall können die für die Messung von reeller Amplitude, Phase und Frequenz des monochromatischen Signals erforderlichen Anfangszustände nicht mehr hinreichend genau bestimmt werden, woraus sich eine entsprechend ungenaue Voreinstellung der Zustände des IIR-Filters ergibt. Die genaue Bestimmung der Anfangszustände x(O), x(1) ist abhängig von dem Signal-zu-Rauschabstand SNR, der durch folgende Formeln definiert wird

$$SNR = \frac{A^2}{\sigma_n^2} \; ; \qquad \sigma_n^2 = E(|r(n)|^2). \tag{23}$$

wobei $\sigma_n^2$ die Varianz und E den Erwartungswert bedeuten.

In den Beispielen gemäß FIG. 5a bis 8b wird das Einschwingverhalten eines IIR-Filters (Filterparameter: elliptisches Filter 6ter Ordnung, Hochpaß, Durchlaßwelligkeit 1dB, Sperrdämpfung 30 dB, Sperrfrequenz $\Omega_S=0.15\pi$, Übergangsbereichsverhältnis $K=\Omega_S/\Omega_p=0.98$) auf ein Signal entsprechend SNR dargestellt. Diese Darstellung entspricht derjenigen der FIG. 4, das heißt, die Figuren 5a, 6a, 7a, 8a beziehen sich auf das IIR-Filter ohne Voreinstellung der Zustände. Dagegen beziehen sich die Figuren 5b, 6b, 7b, 8b auf das IIR-Filter mit voreingestellten Zuständen. Das Einschwingverhalten ist dargestellt in

FIG. 5a, 5b für SNR = 50 dB

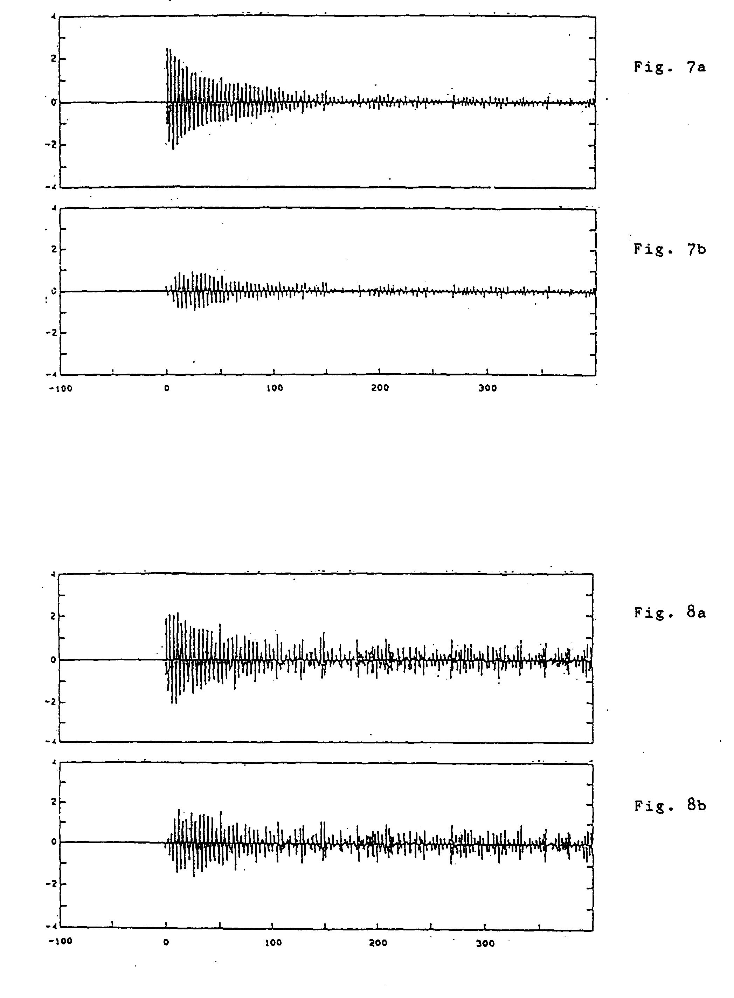

FIG. 6a, 6b für SNR = 40 dB
FIG. 7a, 7b für SNR = 30 dB und
FIG. 8a, 8b für SNR = 20 dB.

Es ist ersichtlich, daß bis zu einem Signal-zu-Rausch-abstand von 30 dB (FIG. 7a, 7b) die Einschwingzeit bei voreingestellten IIR-Filtern in vorteilhafter Weise sehr stark verkürzt wird.

**Patentansprüche**

1. Verfahren zur Signalverarbeitung eines Signals, das einen monochromatischen Signalanteil enthält, mit Hilfe eines digitalen Filters, wobei

   - das Signal in vorgebbarer Weise zeitlich geschaltet vorliegt,

   - das geschaltete Signal in eine Folge von digitalen Abtastwerten mit einer Abtastfrequenz fa umgewandelt und

   - das geschaltete Signal dann verzögert wird um eine Verzögerungszeit, während welcher ein Einstellvorgang am digitalen Filter durchgeführt wird, und

   - das geschaltete Signal erst nach diesem Einstellvorgang an den Eingang des digitalen Filters gelegt wird,

   dadurch gekennzeichnet,

   - daß als digitales Filter ein IIR-Filter verwendet wird,

   - daß zunächst von dem monochromatischen Singalanteil die reelle Amplitude, die Phase sowie die Frequenz bestimmt werden, gemäß den Formeln

$$A = |x(0)| = |x(1)|$$

$$\Phi_1 = -j \ln \frac{x(0)}{A}$$

$$\Omega_1 = -j \ln \frac{x(1)}{x(0)}$$

   mit

EP 0 527 319 B1

A = reelle Amplitude

$\Phi_1$ = Phase zum Abtastzeitpunkt n = 0

$\Omega_1$ = normierte Frequenz, wobei $\Omega_1 = \omega_1/fa$
mit $\omega_1$ = Frequenz des monochromatischen Signalanteils

ln = natürlicher Logarithmus

x(0) = $Ae^{j\Phi_1}$

x(1) = $Ae^{j(\Omega_1 n + \Phi_1)}$

x(0), x(1) = aufeinanderfolgende komplexe Abtastwerte

- daß dann das geschaltete Signal verzögert wird, wobei während der Verzögerungszeit der Zustandsvektor (s(n)) des digitalen Filters entsprechend der reellen Amplitude, der Phase sowie der Frequenz des monochromatischen Signalanteils eingestellt wird, wonach das geschaltete Signal an den Eingang des digitalen Filters gelegt wird.

2. Verfahren nach Anspruch 1, dadurch gekennzeichnet, daß das IIR-Filter in der zweiten direkten Form ausgebildet wird.

3. Verfahren nach einem der vorhergehenden Ansprüche, dadurch gekennzeichnet, daß das digitale Filter eine Kaskadenstruktur enthält mit mindestens einem Untersystem, das in der zweiten direkten Form ausgebildet wird.

4. Verfahren nach einem der vorhergehenden Ansprüche, dadurch gekennzeichnet, daß der Zustandsvektor (s(n)) des digitalen Filters mit Hilfe von zur Einstellung programmierbaren Speicherelementen eingestellt wird.

**Claims**

1. Method for signal-processing of a signal, which contains a monochromatic signal component, with the aid of a digital filter, wherein

- the signal is present switched in time in presettable manner,

- the switched signal is transformed into a sequence of digital scanning values with a scanning frequency fa,

- the switched signal is then delayed by a delay time during which a setting process is carried out at the digital filter and

- the switched signal is applied to the input of the digital filter only after this setting process,

characterised in that

- an infinite impulse response filter is used as the digital filter,

- the actual amplitude, the phase and the frequency are initially determined from the monochromatic signal component according to the formulae

$$A = |x(0)| = |x(1)|$$

$$\Phi_1 = -j \, \ln \frac{x(0)}{A}$$

$$\Omega_1 = -j \ln \frac{x(1)}{x(0)}$$

wherein

| | |
|---|---|
| A = | actual amplitude |
| $\Phi_1$ = | phase at the scanning instant n = 0 |
| $\Omega_1$ = | normalised frequency, wherein $\Omega_1 = \omega_1/fa$, in which $\omega_1$ = frequency of the monochromatic signal component |
| ln = | natural logarithm |
| x(0) = | $Ae^{j\Phi_1}$ |
| x(1) = | $Ae^{j(\Omega_1 n + \Phi_1)}$ |
| x(0), x(1) = | succeeding complex scanning values, |

- then the switched signal is delayed, wherein during the delay time the state vector (s(n)) of the digital filter corresponding to the actual amplitude, the phase and the frequency of the monochromatic signal component is set, whereafter the switched signal is applied to the input of the digital filter.

2. Method according to claim 1, characterised in that the infinite impulse response filter is constructed in the second direct form.

3. Method according to one of the preceding claims, characterised in that the digital filter comprises a cascade structure with at least one sub-system which is constructed in the second direct form.

4. Method according to one of the preceding claims, characterised in that the state vector (s(n)) of the digital filter is set with the aid of storage elements programmable for the setting.

**Revendications**

1. Procédé de traitement d'un signal contenant une composante de signal monochromatique, à l'aide d'un filtre numérique,

- le signal étant commuté temporellement de manière prédéterminée,
- le signal commuté étant converti en une succession de valeurs d'analyse numériques à une fréquence d'analyse fa, et
- le signal commuté étant ensuite différé d'un temps de retard, durant lequel une opération de réglage est effectuée sur le filtre numérique, et
- le signal commuté n'étant appliqué à l'entrée du filtre numérique qu'après cette opération de réglage,

caractérisé

- en qu'un filtre IIR est utilisé en tant que filtre numérique,
- en ce que, tout d'abord, par la composante du signal monochromatique, l'amplitude, la phase ainsi que la fréquence réelles sont déterminées selon les formules

$$A = |x(0)| = |x(1)|$$

$$\Phi_1 = -j \ln \frac{x(0)}{A}$$

$$\Omega_1 = -j \ln \frac{x(1)}{x(0)}$$

A =  amplitude réelle

$\Phi_1$ =  phase à l'instant d'analyse n = 0

$\Omega_1$ =  fréquence normée, $\Omega_1 = \omega_1 / fa$
avec $\omega_1$ = fréquence de la composante de signal monochromatique

ln =  logarithme naturel

x(0) =  $Ae^{j\Phi_1}$

x(1) =  $Ae^{j(\Omega_1 n + \Phi_1)}$

x(0), x(1) =  valeurs d'analyse complexes successives

- en ce qu'ensuite le signal commuté est retardé, durant le temps de retard, le vecteur d'état (s(n)) du filtre numérique est réglé de manière correspondante à l'amplitude, à la phase ainsi qu'à la fréquence réelles de la composante de signal monochromatique, après quoi le signal commuté est appliqué à l'entrée du filtre numérique.

2. Procédé selon la revendication 1, caractérisé en ce que le filtre IIR est réalisé selon la seconde forme directe.

3. Procédé selon l'une quelconque des revendications précédentes, caractérisé en ce que le filtre numérique présente une structure en cascade avec au moins un sous-système qui est réalisé selon la seconde forme directe.

4. Procédé selon l'une quelconque des revendications précédentes, caractérisé en ce que le vecteur d'état (s(n)) du filtre numérique est réglé à l'aide d'éléments de mémoire programmables en vue du réglage.

Fig. 1

Fig. 2

Fig. 3a

instationäres monochromatisches
Signal mit Sprung bei $n=0$

Fig. 3b

stationäres monochromatisches
Signal

Gedächtnis des Filters wird diese
Erinnerung eingeprägt

Fig. 4a

Amplitude des Ausgangssignals ohne Vorinitialisierung des Filters

Fig. 4b

Amplitude des Ausgangssignals mit Vorinitialisierung des Filters

15

Fig. 5a

Fig. 5b

Fig. 6a

Fig. 6b

Fig. 7a

Fig. 7b

Fig. 8a

Fig. 8b